# EUROPEAN PATENT SPECIFICATION

(11) **EP 1 572 590 B1**
(45) Date of publication and mention of the grant of the patent: **28.06.2006**
(21) Application number: 03780908.4
(22) Date of filing: 18.12.2003
(51) Int. Cl.: C01G 23/00

(54) **BARIUM TITANATE AND ELECTRONIC PARTS USING THE MATERIAL**
BATIO3 UND ANWENDUNG DESGLEICHEN IN ELEKTRONISCHEN TEILEN
TITANATE DE BARYUM ET ELEMENTS ELECTRONIQUES COMPRENANT CE MATERIAU

(30) Priority: 18.12.2002 JP 2002367293; 24.02.2003 JP 2003046525; 14.11.2003 JP 2003384842
(43) Date of publication of application: 14.09.2005
(73) Proprietor: Showa Denko K.K., Tokyo 105-8518 (JP)
(72) Inventor: SHIRAKAWA, Akihiko Showa Denko K.K., Chiba-shi, Chiba 267-0056 (JP); YOKOUCHI, Hitoshi ShowaDenko K.K., Chiba-shi, Chiba 267-0056 (JP)
(74) Representative: Strehl Schübel-Hopf & Partner
(86) International application number: PCT/JP2003/016278
(87) International publication number: WO 2004/054931

(56) References cited:
- EP-A- 1 148 030
- US-B1- 6 205 015
- DATABASE WPI Section Ch, Week 199602 Derwent Publications Ltd., London, GB; Class E32, AN 1996-016919 XP002277918 & JP 07 291607 A (MURATA MFG CO LTD), 7 November 1995 (1995-11-07)

## Description

### Cross Reference to Related Application

This application is an application filed under 35 U.S.C. §111(a) claiming benefit, pursuant to 35 U.S.C. §119(e)(1), of the filing date of the Provisional Application No. 60/437,315 filed on January 2, 2003, pursuant to 35 U.S.C. §111(b).

### Technical Field

The present invention relates to barium titanate employed in, for example, dielectric materials, multi-layer ceramic capacitors, and piezoelectric materials, and to a process for producing the barium titanate; and more particularly to a barium titanate containing no internal defects, and to a process for producing the barium titanate.

### Background Art

Barium titanate has been widely employed as a functional material in, among others, dielectric materials, multi-layer ceramic capacitors, and piezoelectric materials. Electronic parts of small size and light weight have been developed and, in accordance with this trend, a demand has arisen for development of a process for producing barium titanate having smaller particle size and exhibiting excellent electric characteristics, such as a high dielectric constant.

Defect-free barium titanate produced through a solid-phase process is known to have a high dielectric constant but, so far, attempts to reduce the particle size of such barium titanate to a desired level have failed. Barium titanate having a small particle size which is produced through a wet synthesis process contains defects, and thus the dielectric constant of such barium titanate cannot be increased satisfactorily.

Examples of processes for producing barium titanate particles include a solid-phase process in which powders of an oxide and a carbonate, serving as raw materials, are mixed in, for example, a ball mill, and the resultant mixture is allowed to react at a temperature as high as about 800°C or higher, to thereby produce a product; an oxalate process in which an oxalic acid complex salt is prepared, and the complex salt is thermally decomposed, to thereby produce barium titanate particles; an alkoxide process in which a metal alkoxide serving as a raw material is subjected to hydrolysis, to thereby yield a precursor; a hydrothermal synthesis process in which a raw material is allowed to react in an aqueous solvent at high temperature and high pressure, to thereby yield a precursor; a process in which a product obtained through hydrolysis of a titanium compound is reacted with a water-soluble barium salt in a strong alkaline aqueous solution (Japanese Patent No. 1891875); a process in which a titanium dioxide sol is reacted with a barium compound in an alkaline aqueous solution (Pamphlet of International Patent Publication WO 00/35811); a process in which a titanium dioxide sol is reacted with a barium compound in a hermetic vessel (Japanese Patent Application Laid-Open (*kokai*) No. 7-291607); and a process in which a raw material having an interstitial hydroxyl group content of 1 wt.% or less is fired under appropriately modified firing conditions, thereby reducing the interstitial hydroxyl group content to 0.1 wt.% (Japanese Patent Application Laid-Open (*kokai*) No. 11-273986).

Although the solid-phase process attains production of defect-free barium titanate particles at low production cost, barium titanate particles produced through the process have a large particle size, and the particles are unsuitable for use as a functional material such as a dielectric material or a piezoelectric material.

The oxalate process enables production of particles having a particle size smaller than that of particles produced through the solid-phase process. However; particles produced through the oxalate process contain carbonate groups derived from oxalic acid. The particles also contain hydroxyl groups originating from water incorporated into the inside thereof. Although these hydroxyl groups can be removed by heating, voids are known to be provided inside the particles during heating (Proceedings of 15th Autumn Symposium of The Ceramic Society of Japan, p. 149). Therefore, the oxalate - process cannot produce barium titanate exhibiting excellent electric characteristics.

The alkoxide process and the hydrothermal synthesis process enable production of barium titanate having a very small particle size. However, the thus-produced barium titanate contains a large amount of hydroxyl groups originating from water. Although these hydroxyl groups can be removed by heating, voids are formed inside the particles during heating. Therefore, the barium titanate fails to exhibit excellent electric characteristics. Barium titanate produced through the alkoxide process contains carbonate groups.

As the hydrothermal synthesis process is carried out at high temperature and high pressure, the process requires exclusive equipment and, thus, the production cost increases.

The processes disclosed in Japanese Patent No. 1841875, Pamphlet of International Patent Publication WO 00/35811, and Japanese Patent Application Laid-Open (*kokai*) No. 7-291607 require a washing step. During the washing step, elution of barium and incorporation of hydroxyl groups into barium titanate occur. Although these hydroxyl groups can be removed by heating, voids are formed inside the particles during heating. Therefore, the barium titanate fails to exhibit excellent electric characteristics. In the process disclosed in Japanese Patent Application Laid-Open (*kokai*) No. 7-291607, reaction is performed in a hermetic vessel with heating while the reaction mixture is stirred with a pulverization medium. Thus, the process requires exclusive equipment and, thus, the production cost increases, which is problematic.

Japanese Patent Application Laid-Open (*kokai*) No. 11-273986 proposes a process for decreasing interstitial hydroxyl groups. However, the process reduces the amount of originally present interstitial hydroxyl groups, and the hydroxyl group content can be reduced only to about 0.1 wt.%. Thus, the process is unsatisfactory from the viewpoint of an increase in dielectric constant.

The present invention contemplates provision of a barium titanate having a small particle size, containing small amounts of unwanted impurities, and exhibiting excellent electric characteristics, which can be employed for forming a dielectric ceramic thin film required for a small-sized capacitor which enables production of a small-sized electronic apparatus; and an electronic part using the barium titanate.

### Summary of the Invention

As a result of extensive investigations aimed at solving the aforementioned problems, the present inventors have found that, when a titanium dioxide sol is reacted with a barium compound in an alkaline solution containing a basic compound, the basic compound is removed in the form of gas after completion of reaction, and the resultant reaction mixture is fired, there can be produced barium titanate having a small particle size and no defects, which cannot be produced through a conventional production process. The present invention has been accomplished on the basis of this finding.

Accordingly, the present invention provides the following.
(1) A barium titanate, which is single crystal in the form of particles, said particles comprising particles without a void having a diameter of 1 nm or more in an amount of 20% or more by number of the total particles.
(2) The barium titanate according to (1) above, wherein said particles comprises particles without a void having a diameter of 1 nm or more in an amount of 50% or more by number of the total particles.
(3) The barium titanate according to (1) above, wherein said particles comprises particles without a void having a diameter of 1 nm or more in an amount of 80% or more by number of the total particles.
(4) The barium titanate according to any one of (1) - (3) above, wherein the particles have a BET specific surface area of 0.1 m²/g or more.
(5) The barium titanate according to any one of (1) - (4) above, wherein no abrupt peak is defected at around 3500cm⁻¹ by infrared spectrum analysis of the particles after heat treatment thereof at 700°C.
(6) The barium titanate according to any one of (1) - (5) above, comprising at least one element selected from the group consisting of Sn, Zr, Ca, Sr, Pb, Ho, Nd, Y, La, Ce, Mg, Bi, Ni, Al, Si, Zn, B, Nb, W, Mn, Fe, Cu, and Dy, said at least one element being in an amount of less than 5 mol% (0 mol% inclusive) on the basis of the entirety of BaTiO₃.
(7) The barium titanate according to any one of (1) - (6) above, which is in the form of powder.
(8) The barium titanate according to any one of (1) - (7) above, which is synthesized by wet process.
(9) A slurry comprising the barium titanate according to any one of (1) - (8) above.
(10) A paste comprising the barium titanate according to any one of (1) - (8) above.
(11) A dielectric material comprising barium titanate according to any one of (1) - (8) above.
(12) A dielectric ceramic comprising barium titanate according to any one of (1) - (8) above.
(13) A piezoelectric material comprising barium titanate according to any one of (1) - (8) above.
(14) A piezoelectric ceramic material comprising barium titanate according to any one of (1) - (8) above.
(15) A dielectric film material comprising barium titanate according to any one of (1) - (8) above.
(16) A capacitor comprising a dielectric material according to (11) above.
(17) A capacitor comprising the piezoelectric material according to (13) above.
(18) A capacitor comprising the dielectric film according to (15) above.
(19) An integrated capacitor comprising the dielectric film according to (15) above (formed on or in a substrate).
(20) A printed board comprising the dielectric film according to (15) above.
(21) An electronic equipment comprising the capacitor according to any one of (16) - (19) above.

### Brief Description of the Drawing

Fig. 1 shows a TEM photograph of a barium titanate powder. In the photograph, defects (voids) resulting from removal of hydroxyl groups are observed.
Fig. 2 is a graph showing the dependency of the BET specific surface area on the treated temperature.
Fig. 3 is a graph showing the dependency of the c/a on the treated temperature.
Fig. 4 is a graph showing the dependency of the c/a on the primary particle size.
Fig. 5 is a graph showing the dependency of the lattice axis length on the treated temperature.

### Modes for Carrying Out the Invention

The present invention will be described in detail below.

The barium titanate of the present invention; i.e., BaTiO₃, is one type of perovskite-type compound represented by the formula ABO₃, wherein A is Ba and B is Ti. The barium titanate may comprise at least one element selected from the group consisting of Sn, Zr, Ca, Sr, Pb, Ho, Nd, Y, La, Ce, Mg, Bi, Ni, Al, Si, Zn, B, Nb, W, Mn, Fe, Cu, and Dy, said at least one element being in an amount of less than 5 mol% on the basis of the entirety of BaTiO₃.

One characteristic feature of the barium titanate of the present invention is that the barium titanate contains no hydroxyl groups or defects resulting from removal of hydroxyl groups inside the particles of the barium titanate.

Another characteristic feature of the barium titanate of the present invention is that the barium titanate is single crystal.

A hydroxyl group present in barium titanate is detected through infrared spectrometry as an absorption peak in the vicinity of 3,500 cm⁻¹. In this case, hydroxyl groups present on the surfaces of particles as well as those present inside the particles are detected simultaneously. However, the hydroxyl groups present on the particle surfaces are known to be eliminated at a temperature lower than 700°C. Thus, through heat treatment of the barium titanate at 700°C performed in advance, hydroxyl groups contained inside the particles thereof which lower the dielectric constant can be detected through infrared spectroscopic analysis.

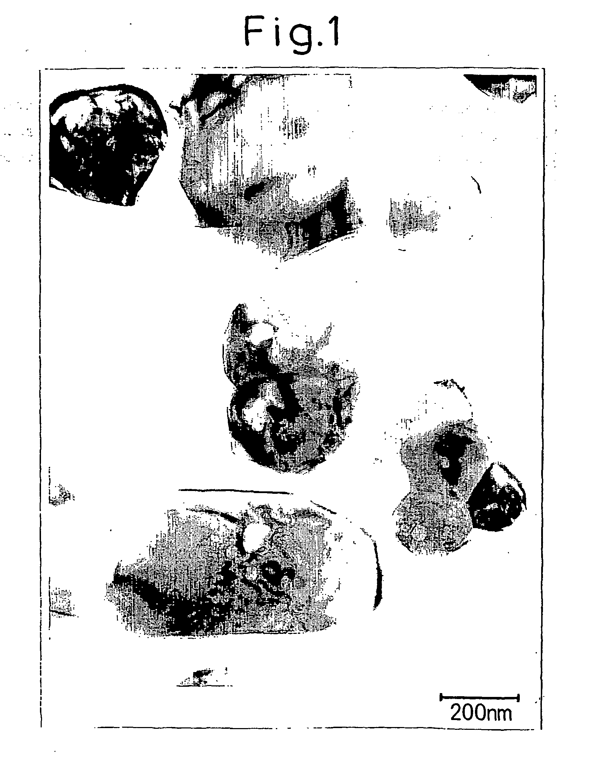

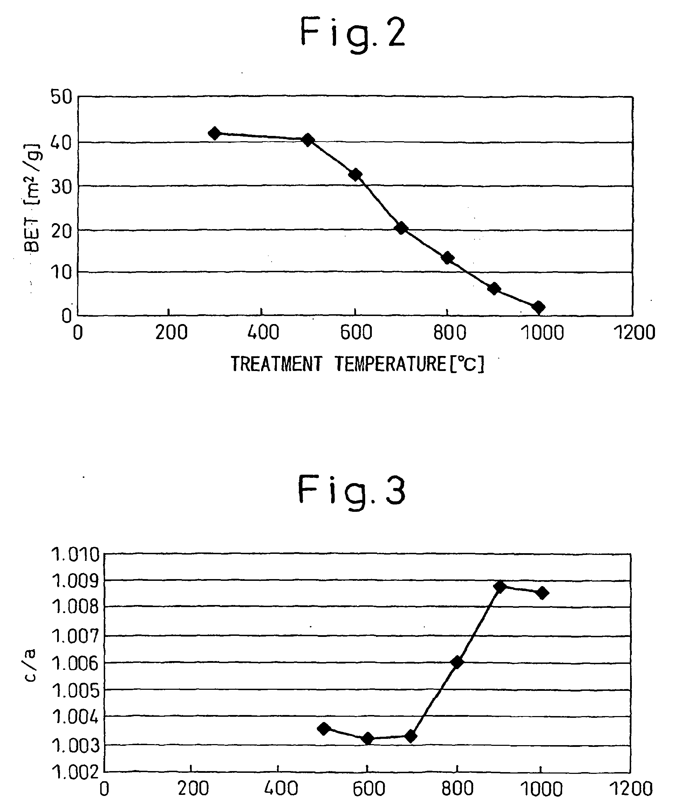

The "defects resulting from removal of hydroxyl groups" refers to "voids" having a diameter of 1 nm or more detected through TEM observation in which thin film produced from barium titanate particles is preferably observed. Such defects or voids are of a type similar to that shown in Fig. 3 (denoted by numeral 22) in Japanese Patent Application Laid-Open (*kokai*) No. 11-273986. Fig. 1 is a TEM photograph showing a barium titanate powder produced in a Comparative Example (photographed at a magnification of 150,000, but in reduced scale in the attached drawing). Since foam-like voids can be identified in the particles observed in the photograph, the voids are determined to be defects resulting from removal of hydroxyl groups.

As the barium titanate has, inside the particles thereof, no hydroxyl groups or defects resulting from removal of hydroxyl groups, the dielectric constant of the barium titanate increases.

As the barium titanate is single crystal, the dielectric constant thereof increases. A lattice image analysis by a TEM can determine if the barium titanate is single crystal.

Since the barium titanate of the present invention is single crystal, the dielectric constant thereof increases.

The barium titanate of the present invention has a small particle size, has a high dielectric constant, and exhibits excellent electric characteristics. Therefore, a small-sized electronic part such as a multi-layer ceramic capacitor is produced from a dielectric material containing the barium titanate, such as a dielectric ceramic material. Furthermore, an electronic apparatus of small size and a light weight can be produced from such an electronic part.

In general, barium titanate having a BET specific surface area of less than 0.1 m²/g; i.e., barium titanate having a very large particle size, is not effective for producing a small-sized electronic apparatus. In contrast, barium titanate having a BET specific surface area of more than 0.1 m²/g, more preferably 1 m²/g, further preferably 5 m²/g, is effective for producing a small-sized electronic apparatus.

The production process employed in the present invention is not particularly limited, but wet process is preferred in which titanium oxide sol is preferably used as a starting material.

No particular limitation is imposed on the titanium dioxide sol employed in the present invention, but a titanium dioxide sol containing brookite crystals is preferred. So long as the titanium dioxide sol comprises brookite crystals, the titanium dioxide sol may comprise brookite titanium dioxide singly, or the titanium dioxide sol may comprise rutile titanium dioxide and anatase titanium dioxide. When the titanium dioxide sol comprises rutile titanium dioxide and anatase titanium dioxide, no particular limitation is imposed on the amount of brookite titanium dioxide comprised in the sol. The amount of the brookite titanium dioxide is typically 1 to 100 mass%, preferably 10 to 100 mass%, more preferably 50 to 100 mass%, further preferably 70 to 100 mass%. In order to enhance dispersibility of titanium dioxide particles in a solvent, titanium dioxide having a crystalline structure rather than an amorphous structure is preferably employed, since titanium dioxide having a crystalline structure tends to remain in the form of primary particles. Particularly, brookite titanium dioxide is preferred, as it exhibits excellent dispersibility. The reason why brookite titanium dioxide exhibits excellent dispersibility has not been clarified but, conceivably, the high dispersibility of brookite titanium dioxide relates to brookite titanium dioxide having a zeta potential higher than that of rutile titanium dioxide or anatase titanium dioxide.

Examples of the process for producing titanium dioxide particles containing brookite crystals include a production process in which anatase titanium dioxide particles is subjected to heat treatment, to thereby produce titanium dioxide particles containing brookite crystals; and a liquid-phase production process in which a solution of a titanium compound such as titanium tetrachloride, titanium trichloride, titanium alkoxide, or titanium sulfate is neutralized or hydrolyzed, to thereby produce a titanium dioxide sol containing dispersed titanium dioxide particles.

When barium titanate particles are produced from titanium dioxide particles comprising brookite crystals, from the viewpoints of small size of the titanium dioxide particles and excellent dispersibility of the particles, a preferred process therefor is such that a titanium salt is hydrolyzed in an acidic solution to thereby produce titanium dioxide particles in the form of titanium dioxide sol. Specifically, the following processes are preferred: a process in which titanium tetrachloride is added to hot water of 75 to 100 °C, and the titanium tetrachloride is hydrolyzed at a temperature falling within the range of 75°C to the boiling point of the solution, while the concentration of chloride ions is controlled, to thereby produce titanium dioxide particles comprising brookite crystals in the form of titanium dioxide sol (Japanese Patent Application Laid-Open (*kokai*) No. 11-043327); and a process in which titanium tetrachloride is added to hot water of 75 to 100°C and, in the presence of either or both of nitrate ions and phosphate ions, the titanium tetrachloride is hydrolyzed at a temperature falling within the range of 75°C to the boiling point of the solution, while the total concentration of chloride ions, nitrate ions, and phosphate ions is controlled, to thereby produce titanium dioxide particles containing brookite crystals in the form of titanium dioxide sol (International Patent Publication WO 99/58451).

The thus-produced titanium dioxide particles comprising brookite crystals preferably have a primary particle size of 5 to 50 nm. When the primary particle size exceeds 50 nm, barium titanate particles produced from the titanium dioxide particles have a large particle size, and the complex oxide particles are unsuitable for use as a functional material such as a dielectric material or a piezoelectric material. In contrast, when the primary particle size is less than 5 nm, a difficulty is encountered in handling the titanium dioxide particles during the production thereof.

In the production process employed in the present invention, when a titanium dioxide sol obtained through hydrolysis of a titanium salt in an acidic solution is employed, no particular limitation is imposed on the crystal form of titanium dioxide particles comprised in the sol; i.e., the crystal form of the titanium dioxide particles is not limited to brookite.

When a titanium salt such as titanium tetrachloride or titanium sulfate is hydrolyzed in an acidic solution, as the reaction rate is reduced, compared with the case where hydrolysis is carried out in a neutral or alkaline solution, a titanium dioxide sol comprising titanium dioxide particles having a primary particle size and exhibiting excellent dispersibility is produced. In addition, since anions such as chloride ions and sulfate ions tend not to enter the thus-produced titanium dioxide particles, when barium titanate particles are produced from the titanium dioxide sol, the amount of anions which enter the barium titanate particles can be reduced.

Meanwhile, when a titanium salt is hydrolyzed in a neutral or alkaline solution, the reaction rate increases and large amounts of nuclei are generated in an early stage. As a result, a titanium dioxide sol containing titanium dioxide particles of small size but exhibiting poor dispersibility is produced, and the titanium dioxide particles form wig-shaped aggregates. When barium titanate particles are formed from such a titanium dioxide sol, although the resultant particles have a small particle size, the particles exhibits poor dispersibility. In addition, anions tend to enter the inside of the titanium dioxide particles, and removal of the anions in the subsequent step becomes difficult.

No particular limitation is imposed on the process for producing a titanium dioxide sol through hydrolysis of a titanium salt in an acidic solution, so long as acidity of the resultant reaction mixture can be maintained. However, preferably, there is carried out a process in which a titanium tetrachloride serving as a raw material is hydrolyzed in a reactor equipped with a reflux condenser, and escape of the thus-generated chlorine from the reactor is suppressed, thereby maintaining acidity of the resultant reaction mixture (Japanese Patent Application Laid-Open (*kokai*) No. 11-43327).

The concentration of a titanium salt (i.e., a raw material) contained in an acidic solution is preferably 0.01 to 5 mol/L. When the concentration exceeds 5 mol/L, the reaction rate of hydrolysis increases, and thus a titanium dioxide sol comprising titanium dioxide particles of large particle size and exhibiting poor dispersibility is obtained, whereas when the concentration is less than 0.01 mol/L, the concentration of the resultant titanium dioxide decreases, resulting in poor productivity.

The barium compound employed in the production process of the present invention preferably exhibits water-solubility. Typically, the barium compound is, for example, a hydroxide, a nitrate, an acetate, or a chloride. These compounds may be employed singly, or in combination of two or more species by mixing at arbitrary proportions. Specific examples of the barium compound which may be employed include barium hydroxide, barium chloride, barium nitrate, and barium acetate.

The barium titanate of the present invention can be produced through a process in which titanium dioxide particles comprising brookite crystals are reacted with a barium compound or a process in which a titanium salt is hydrolyzed in an acidic solution, and the resultant titanium dioxide sol is reacted with a barium compound.

Preferably, a reaction is caused to proceed in an alkaline solution containing a basic compound. The pH of the solution is preferably at least 11, more preferably at least 13, particularly preferably at least 14. When the pH of the solution is adjusted to at least 14, barium titanate particles having smaller particle size can be produced. Preferably, a basic compound (e.g., an organic basic compound) is added to the resultant reaction mixture, to thereby maintain an alkaline milieu; i.e., the pH of the mixture at 11 or more. If the pH is lower than 11, the reactivity of titanium oxide sol and barium compound decreases so that it is difficult to obtain barium titanate with a high dielectric constant.

No particular limitation is imposed on the basic compound to be added but, preferably, the basic compound is a substance which can be gasified through evaporation, sublimation, and/or thermal decomposition at or below a temperature at which firing of barium titanate is performed and at atmospheric pressure or reduced pressure. Preferred examples of the basic compound which may be employed include TMAH (tetramethylammonium hydroxide) and choline. When an alkali metal hydroxide such as lithium hydroxide, sodium hydroxide, or potassium hydroxide is added, such an alkali metal remains in the resultant barium titanate particles. Therefore, when the composite oxide particles are subjected to molding and sintering, to thereby form a functional material such as a dielectric material or a piezoelectric material, the properties of the functional material may deteriorate. Thus, addition of the aforementioned basic compound (e.g., tetramethylammonium hydroxide) is preferred.

Furthermore, when the concentration of carbonate groups (including carbonate species such as CO₂, H₂CO₃, HCO₃⁻, and CO₃²⁻) contained in the reaction mixture is controlled, barium titanate having a large dielectric constant can be successfully produced.

The concentration of a carbonate group contained in the reaction mixture (as reduced to CO₂, hereinafter the same shall apply unless otherwise specified) is preferably 500 mass ppm or less, more preferably 1 to 200 mass ppm, particularly preferably 1 to 100 mass ppm. When the concentration of carbonate groups falls outside this range, barium titanate having a large dielectric constant may fail to be produced.

In the reaction mixture, preferably, the concentration of titanium dioxide particles or a titanium dioxide sol is regulated to 0.1 to 5 mol/L, and the concentration of a barium-containing metallic salt as reduced to a metal oxide is regulated to 0.1 to 5 mol/L.

In addition, a compound of at least one element selected from the group consisting of Sn, Zr, Ca, Sr, Pb, Ho, Nd, Y, La, Ce, Mg, Bi, Ni, Al, Si, Zn, B, Nb, W, Mn, Fe, Cu, and Dy may be added to the reaction mixture such that the resultant barium titanate contains such an element in an amount of less than 5 mol% on the basis of the entirety of BaTiO₃. These elements may be predominantly present on the surface of particles. When, for example, a capacitor is produced from the barium titanate, the type and amount of the element added to the reaction mixture may be determined in accordance with intended characteristics (including temperature characteristics) of the capacitor.

While being stirred, at ambient pressure, the thus-prepared alkaline solution is typically heated to 40°C to the boiling point of the solution, preferably 80°C to the boiling point of the solution, to thereby allow a reaction to proceed. The reaction time is typically at least one hour, preferably at least four hours. In general, a slurry obtained through the reaction is subjected to a process employing, for example, electrodialysis, ion exchange, washing with water, washing with acid, or permeation membrane, to thereby remove impurity ions. However, while the impurity ions are removed, barium contained in the resultant barium titanate is ionized and partially dissolved in the slurry, and thus compositional proportions of the barium titanate are not regulated to the desired proportions. In addition, as crystal defects are generated in the barium titanate, the dielectric constant of the barium titanate is reduced. Therefore, preferably, removal of impurities such as a basic compound is carried out through the below-described process rather than the aforementioned process.

When a slurry produced through the above-described reaction is subjected to firing, the particles of the present invention can be produced. Through firing of the slurry, crystallinity of barium titanate particles can be enhanced, and impurities remaining in the slurry, such as anions (e.g., chloride ions, sulfate ions, and phosphate ions) and a basic compound (e.g., tetramethylammonium hydroxide), can be removed in the form of gas through evaporation, sublimation, and/or thermal decomposition. Typically, firing is carried out at 300 to 1,200°C. No particular limitation is imposed on the firing atmosphere, but typically, firing is carried out in air.

If desired, from the viewpoint of handing, the slurry may be subjected to solid-liquid separation before firing. The solid-liquid separation process includes the steps of precipitation, concentration, filtration, and/or drying. When the steps of precipitation, concentration, and filtration are carried out, a flocculant or a dispersant may be employed in order to increase (or decrease) the precipitation rate or the filtration rate. In a drying step, liquid components are evaporated or sublimated through, for example, reduced-pressure drying, hot-air drying, or freeze-drying.

Before firing of the slurry, impurities such as a basic compound may be removed in the form of gas from the slurry at a temperature falling within a range of room temperature to a temperature at which firing is performed and at atmospheric or a reduced pressure.

The thus-produced barium titanate has, inside the particles thereof, no hydroxyl groups or defects resulting from removal of hydroxyl groups and exhibits excellent electric characteristics. As mentioned hereinbefore, such a hydroxyl group is detected through infrared spectrometry as an absorption peak in the vicinity of 3,500 cm⁻¹. Through heat treatment of the barium titanate at 700°C performed in advance, hydroxyl groups contained inside the particles thereof which lower the dielectric constant can be detected through infrared spectroscopic analysis. The defects resulting from removal of hydroxyl groups are detected as voids having a diameter of 1 nm or more through TEM observation.

When a thin film produced from conventionally known barium titanate is minutely examined, almost, every particle has voids, with rare exceptions, in that about five or fewer particles out of 100 particles may contain no voids. However, with the barium titanate produced in the working examples of the present invention, no defect (void) resulting from removal of hydroxyl groups was observed in a sample of hundreds of particles. In other words, according to the present invention, the percentage in number of barium titanate particles containing no defects (voids) resulting from removal of hydroxyl groups with respect to the entire particles is at least 20%, preferably at least 50%, more preferably at least 80%, still more preferably at least 90%, particularly preferably at least 98%. The ratio can be elevated to virtually 100%.

While the dielectric constant of barium titanate increases if it is single crystal, it was confirmed by TEM lattice analysis that barium titanate of the present invention is single crystal.

A film with a high dielectric constant may be obtained by dispersing a filler including the barium titanate of the present invention in at least one selected from the group consisting of thermosetting resins and thermoplastic resins.

The fillers other than barium titanate, which may be used, include alumina, titania, zirconia, tantalun oxide, etc., and combination thereof.

The thermosetting resins and thermoplastic resins are not particularly limited and may be commonly used resins. The thermosetting resins preferably are epoxy reins, polyimide resins, polyamide resins, bistriazine resins, etc. and the thermoplastic resins are preferably polyolefin resins, styrene resins, polyamide resins, etc.

It is preferred that in order to uniformly disperse a filler including the barium titanate of the present invention in at least one thermosetting resin and/or - thermoplastic resin, a filler is preliminarily dispersed in a solvent or a mixture of the resin and a solvent to form a slurry.

The method of dispersing a filler in a solvent or a mixture of the resin and a solvent to form a slurry is not particularly limited but preferably comprises a wet disassociating step.

The solvent, which is not particularly limited, may be any solvent which is usually used, for example, methylethyle ketone, toluene, ethyl acetate, methanol, ethanol, N,N-dimethyl formamide, N,N-dimethyl acetamide, N-methylpyrrolidone, methyl cellosolve, etc. These may be used alone or in combination.

A coupling agent may be preferably added to obtain a slurry in which the filler is dispersed in a solvent or a mixture of a solvent and the above resin. The coupling agent is not particularly limited but may be, for example, a silane coupling agent, a titanate-based coupling agent, and an aluminate-based coupling agent. As the hydrophilic group of a coupling agent reacts with active hydrogen on the surface of the filler and covers the surface, the dispersibility of the filler into a solvent is improved. The hydrophobic group of the coupling agent may improve the compatibility with the resin by selecting the group. For example, when the resin used is an epoxy resin, a silane coupling agent having a functional group such as monoamino, diamino, cationicstyril, epoxy, mercapto, anilino and ureido, or a titanate-based coupling agent having a functional group such as phosphite, amino, diamino, epoxy and mercapto is preferred. When the resin used is a polyimide resin, a silane coupling agent having a functional group such as monoamino and diamino and anilino, or a titanate-based coupling agent having a functional group such as monoamino and diamino is preferred. The above coupling agents may be used alone or in combination.

The amount of the coupling agent is not particularly limited and is sufficient if a portion or all of the surface of the barium titanate particles is covered. If the amount of the coupling agent is too high, the remaining unreacted coupling agent may be affected and, if it is too low, the coupling effect may be lowered. Therefore, depending on the particle size and specific surface area of the filler including the barium titanate and kind of the coupling agent, the amount of the coupling agent should be selected such that the filler can be uniformly dispersed, but about 0.05 to 20% by mass based on the mass of the filler including barium titanate is desired.

It is preferred to include a heating step for the slurry, in order to complete the reaction between the hydrophilic group of the coupling agent and the active hydrogen on the surface of the filler including barium titanate. The heating temperature and the time are not particularly limited but are preferred to be 100-150°C and for 1 to 3 hours. When the boiling point of the solvent of the solvent is 100°C or less, it is preferred that the heating temperature is not higher than the boiling point of the solvent and the heating time period is accordingly lengthened.

The barium titanate of the present invention or the slurry comprising the barium titanate of the present invention can provide a dielectric film which has excellent dielectric properties.

The above dielectric film can be applied to a capacitor in or on a substrate (for example integral capacitor) since its dielectric properties are so excellent that a thin film made from the dielectric film can have excellent dielectric properties. When such a capacitor can be used in an electronic equipment such as a cellular phone or a digital camera, it is very useful in making the equipment miniaturized, lightened and to have a higher performance.

### Examples

The present invention will next be described in detail by way of Examples and Comparative Examples, which should not be construed as limiting the invention thereto.

### (Method of measuring dielectric constant)

The dielectric constant of the obtained barium titanate was measured in the following manner.

Barium titanate, MgO (High purity magnesium oxide 500-04R, produced by Kyowa Chemical Industries, Inc.), HO₂O₃ (powder holmium oxide, produced by Nippon yttrium K.K.), and BaSiO₃ (produced by Soekawa Rikagaku K.K.) were mixed at a molar ratio of 100:0.5:0.75:1.0. 0.3g of the mixed powder was uniaxially shaped in a mold with a diameter of 13mm and then fired at 1300°C in a nitrogen atmosphere for 2 hours. The sizes of the obtained sintered body were precisely measured. The sintered body was coated with a silver electrode paste for firing and fired at 800°C in an air atmosphere for 10 minutes to form a single plate capacitor with electrodes.

The static capacitance of the above capacitor was measured by an LF impedance analyzer 4192A, manufactured by Hewlett Packard Co., and the dielectric constant was calculated from the static capacitance measured at a frequency of 1kHz and a temperature changed from 55°C to 125°C as well as the sizes of the sintered body.

### Example 1:

An aqueous solution containing 0.25 mol/L titanium tetrachloride (product of Sumitomo Titanium, purity: 99.9%) was placed in a reactor equipped with a reflux condenser, and the solution was heated to a temperature near its boiling point, while escape of chloride ions was suppressed, whereby acidity of the solution was maintained. The solution was maintained at the same temperature for 60 minutes, and the titanium tetrachloride was hydrolyzed, to thereby yield a titanium dioxide sol. A portion of the thus-obtained titanium dioxide sol was dried at 110°C, and the titanium dioxide was subjected to crystallographic analysis by use of an X-ray diffraction apparatus (RAD-B Rotor Flex, product of Rigaku Corporation). As a result, the titanium dioxide was found to be brookite titanium dioxide.

Barium hydroxide octahydrate (product of Barium Chemicals Co., Ltd.) (126 g), and an aqueous solution (456 g) -which had been prepared by feeding carbon dioxide gas to a 20 mass% aqueous solution of tetramethylammonium hydroxide (product of Sachem Showa) such that the concentration of a carbonate group contained in the solution was adjusted to 60 mass ppm (as reduced to CO₂, hereinafter the same shall apply unless otherwise specified)- were added to a reactor equipped with a reflux condenser, and the resultant mixture was heated to 95°C in the reactor while the pH of the mixture was maintained at 14. A titanium dioxide sol (titanium dioxide concentration: 15 mass%) (213 g) which had been prepared through precipitation and concentration of the above-obtained titanium dioxide sol was added dropwise to the reactor at a rate of 7 g/minute.

The resultant mixture was heated to 110°C, and maintained at the same temperature, under stirring, for four hours, to thereby allow a reaction to proceed. The thus-produced slurry was left to cool to 50°C, and then the thus-cooled slurry was subjected to filtration. The filter cake was dried at 300°C for five hours, to thereby produce a fine powder. The actual yield of the powder was found to be 99.8% of the theoretical yield calculated from the amounts of the titanium dioxide and barium hydroxide employed in the reaction.

The obtained fine powder was found to be single crystal by observation with TEM. 5g of the fine powder was placed on a ceramic dish and heated at a temperature elevation rate of 20°C/min in an electric furnace and kept or fired at a temperature as shown in Table 1 for 2 hours, followed by being allowed to cool.

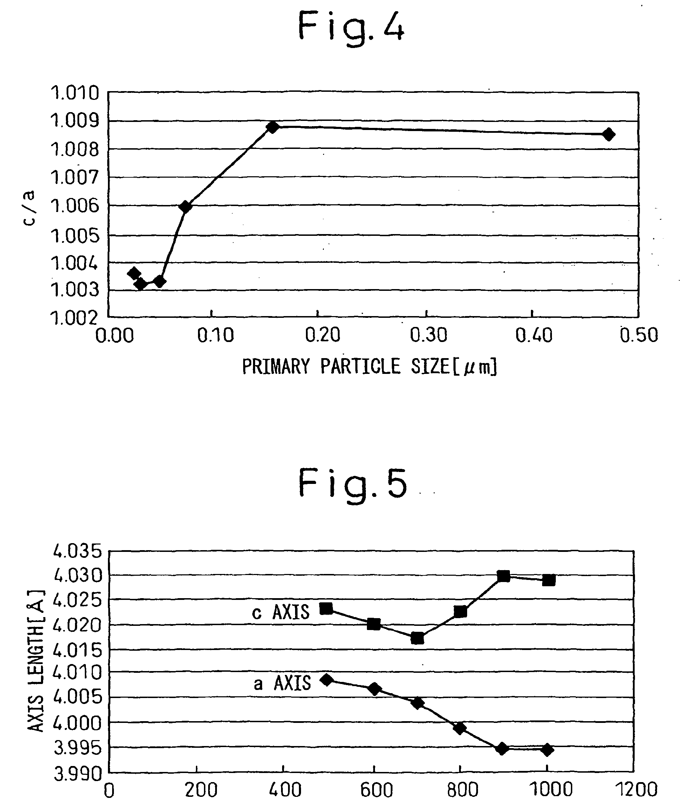

The resultant powder was subjected to X-ray diffraction analysis by use of an X-ray diffraction apparatus (RAD-B Rotor Flex, product of Rigaku Corporation). As a result, the powder was found to be perovskite-type BaTiO₃. On the basis of X-ray diffraction intensity data, the c/a ratio of the powder was obtained by means of a Rietveld method, and found to be 1.0104. The specific surface area S of the powder, as measured on the basis of the BET method, was found to be 7.1 m²/g. The results thus obtained are shown in Table 1 and Figs. 2-5.

The carbonate group content of the sample obtained by firing at 950°C was determined by use of an infrared spectroscopic analyzer (FTS 6000, product of BIORAD). The carbonate group content was found to be about 1 mass% as reduced to barium carbonate. The sample was found to exhibit no steep absorption peak in the vicinity of 3,500 cm⁻¹ attributed to an interstitial hydroxyl group. The dielectric constant at 25°C was 3200. The temperature characteristic thereof satisfied the X7R characteristic of the CLASS II classification code of EIA standard (United States Mechanical Industries Association Standard). A dielectric ceramic, dielectric film, capacitor and dielectric material obtained from the above barium titanate were excellent in their characteristics.

### Example 2:

A perovskite-type BaTiO₃ was produced in a manner similar to that of Example 1. The BaTiO₃ was crystallized at 600°C for two hours. The specific surface area and c/a ratio of the resultant BaTiO₃ were measured in a manner similar to that of Example 1, and found to be 25 m²/g and 1.0032, respectively. Infrared spectroscopic analysis was performed in a manner similar to that of Example 1, except that the sample was.heated at 700°C. As a result, the sample was found not to exhibit a steep absorption peak in the vicinity of 3,500 cm⁻¹ attributed to an interstitial hydroxyl group. The dielectric constant at 25°C was 1100. The temperature characteristic thereof satisfied the X7R characteristic of EIA standard. A dielectric ceramic, dielectric film, capacitor and dielectric material obtained from the above barium titanate were excellent in their characteristics.

### Example 3:

A perovskite-type BaTiO₃ was produced in a manner similar to that of Example 1. The BaTiO₃ was crystallized at 950°C for two hours. The specific surface area and c/a ratio of the resultant BaTiO₃ were measured in a manner similar to that of Example 1, and found to be 4.1 m²/g and 1.0092, respectively. Infrared spectroscopic analysis was performed in a manner similar to that of Example 1. As a result, the sample was found not to exhibit a steep absorption peak in the vicinity of 3,500 cm⁻¹ attributed to an interstitial hydroxyl group. The dielectric constant at 25°C was 3600. The temperature characteristic thereof satisfied the X7R characteristic of EIA standard. A dielectric ceramic, dielectric film, capacitor and dielectric material obtained from the above barium titanate were excellent in their characteristics. A TEM image of the sample at a magnification of 250,000 showed no void resulting from removal of hydroxyl groups.

### Example 4:

A perovskite-type BaTiO₃ was produced in a manner similar to that of Example 1. The BaTiO₃ was crystallized at 1,200°C for two hours. The specific surface area and c/a ratio of the resultant BaTiO₃ were measured in a manner similar to that of Example 1, and found to be 0.5 m²/g and 1.0110, respectively. Infrared spectroscopic analysis was performed in a manner similar to that of Example 1. As a result, the sample was found not to exhibit a steep absorption peak in the vicinity of 3,500 cm⁻¹ attributed to an interstitial hydroxyl group. The dielectric constant at 25°C was 4000. The temperature characteristic thereof satisfied the X7R characteristic of EIA standard. A dielectric ceramic, dielectric film, capacitor and dielectric material obtained from the above barium titanate were excellent in their characteristics. A TEM image of the sample at a magnification of 250,000 showed no void resulting from removal of hydroxyl groups.

### Example 5:

The procedure of Example 1 was repeated, except that the amount of TMAH to be added was reduced and the pH of the alkaline solution was changed to 11, to thereby synthesize a barium titanate. The actual yield of the barium titanate was found to be 98% of the theoretical yield. The barium titanate was single crystal by TEM analysis. The barium titanate sample crystallized at 880°C for two hours was measured in a manner similar to that of Example 1, and found had the specific surface area and c/a ratio of the resultant sample were 7.3 m²/g and 1.0090, respectively. Infrared spectroscopic analysis was performed in a manner similar to that of Example 1. As a result, the sample was found not to exhibit a steep absorption peak in the vicinity of 3,500 cm⁻¹ attributed to an interstitial hydroxyl group. The dielectric constant at 25°C was 2600. The temperature characteristic thereof satisfied the X7R characteristic of EIA standard. A dielectric ceramic, dielectric film, capacitor and dielectric material obtained from the above barium titanate were excellent in their characteristics.

### Example 6:

The procedure of Example 1 was repeated, except that a choline aqueous solution having a carbonate group content of 75 mass ppm was employed in place of the TMAH aqueous solution, to thereby synthesize a barium titanate. The actual yield of the barium titanate was found to be 99.9% of the theoretical yield. The barium titanate was single crystal by TEM analysis. The barium titanate sample crystallized at 880°C for two hours was measured in a manner similar to that of Example 1, and found had the specific surface area and c/a ratio of the resultant sample were 7 m²/g and 1.0091, respectively. Infrared spectroscopic analysis was performed in a manner similar to that of Example 1. As a result, the sample was found not to exhibit a steep absorption peak in the vicinity of 3,500 cm⁻¹ attributed to an interstitial hydroxyl group. The dielectric constant at 25°C was 2700. The temperature characteristic thereof satisfied the X7R characteristic of EIA standard. A dielectric ceramic, dielectric film, capacitor and dielectric material obtained from the above barium titanate were excellent in their characteristics.

### Example 7:

The procedure of Example 1 was repeated, except that a commercially available anatase titanium dioxide sol (STS-02, product of Ishihara Sangyo Co., Ltd.) was employed in place of the brookite titanium dioxide sol synthesized in Example 1, to thereby synthesize a barium titanate. The actual yield of the barium titanate was found to be 99.8% of the theoretical yield. The barium titanate was single crystal by TEM analysis. The barium titanate sample crystallized at 880°C for two hours was measured in a manner similar to that of Example 1, and found had the specific surface area and c/a ratio of the resultant sample were 7.7 m²/g and 1.0071, respectively. Infrared spectroscopic analysis was performed in a manner similar to that of Example 1. As a result, the sample was found not to exhibit a steep absorption peak in the vicinity of 3,500 cm⁻¹ attributed to an interstitial hydroxyl group. The dielectric constant at 25°C was 2400. The temperature characteristic thereof satisfied the X7R characteristic of EIA standard. A dielectric ceramic, dielectric film, capacitor and dielectric material obtained from the above barium titanate were excellent in their characteristics.

### Example 8:

The procedure of Example 1 was repeated, except that a TMAH having a carbonate group content of 110 mass ppm was employed in place of the TMAH having a carbonate group content of 60 mass ppm, to thereby synthesize a barium titanate. The actual yield of the barium titanate was found to be 99.8% of the theoretical yield. The barium titanate was single crystal by TEM analysis. The barium titanate sample crystallized at 880°C for two hours was measured in a manner similar to that of Example 1, and found had the specific surface area and c/a ratio of the resultant sample were 7.3 m²/g and 1.0090, respectively. Infrared spectroscopic analysis was performed in a manner similar to that of Example 1. As a result, the sample was found not to exhibit a steep absorption peak in the vicinity of 3,500 cm⁻¹ attributed to an interstitial hydroxyl group.

The dielectric constant at 25°C was 2700. The temperature characteristic thereof satisfied the X7R characteristic of EIA standard. A dielectric ceramic, dielectric film, capacitor and dielectric material obtained from said barium titanate were excellent in their characteristics.

### Example 9:

The procedure of Example 1 was repeated, except that a TMAH having a carbonate group content of 215 mass ppm was employed in place of the TMAH having a carbonate group content of 60 mass ppm, to thereby synthesize a barium titanate. The actual yield of the barium titanate was found to be 99.7% of the theoretical yield. The barium titanate was single crystal by TEM analysis. The barium titanate sample crystallized at 880°C for two hours was measured in a manner similar to that of Example 1, and found had the specific surface area and c/a ratio of the resultant sample were 7.5 m²/g and 1.0087, respectively. Infrared spectroscopic analysis was performed in a manner similar to that of Example 1. As a result, the sample was found not to exhibit a steep absorption peak in the vicinity of 3,500 cm⁻¹ attributed to an interstitial hydroxyl group. The dielectric constant at 25°C was 2500. The temperature characteristic thereof satisfied the X7R characteristic of EIA standard. A dielectric ceramic, dielectric film, capacitor and dielectric material obtained from the above barium titanate were excellent in their characteristics.

### Example 10:

The procedure of Example 1 was repeated, except that a TMAH having a carbonate group content of 490 mass ppm was employed in place of the TMAH having a carbonate group content of 60 mass ppm, to thereby synthesize a barium titanate. The actual yield of the barium titanate was found to be 99.4% of the theoretical yield. The barium titanate was single crystal by TEM analysis. The barium titanate sample crystallized at 880°C for two hours was measured in a manner similar to that of Example 1, and found had the specific surface area and c/a ratio of the resultant sample were 8.1 m²/g and 1.0061, respectively. Infrared spectroscopic analysis was performed in a manner similar to that of Example 1. As a result, the sample was found not to exhibit a steep absorption peak in the vicinity of 3,500 cm⁻¹ attributed to an interstitial hydroxyl group. The dielectric constant at 25°C was 2000. The temperature characteristic thereof satisfied the X7R characteristic of EIA standard. A dielectric ceramic, dielectric film, capacitor and dielectric material obtained from the above barium titanate were excellent in their characteristics.

### Example 11:

The procedure of Example 1 was repeated, except that a commercially available anatase titanium dioxide sol (ST-02, product of Ishihara Sangyo Co., Ltd.) was employed in place of the brookite titanium dioxide sol synthesized in Example 1, to thereby synthesize a barium titanate. The actual yield of the barium titanate was found to be 99.8% of the theoretical yield. The barium titanate was single crystal by TEM analysis. The barium titanate sample crystallized at 880°C for two hours was measured in a manner similar to that of Example 1, and found had the specific surface area and c/a ratio of the resultant sample 7.7 m²/g and 1.0066, respectively. Infrared spectroscopic analysis was performed in a manner similar to that of Example 1. As a result, the sample was found not to exhibit a steep absorption peak in the vicinity of 3,500 cm⁻¹ attributed to an interstitial hydroxyl group. The dielectric constant at 25°C was 2200. The temperature characteristic thereof satisfied the X7R characteristic of EIA standard. A dielectric ceramic, dielectric film, capacitor and dielectric material obtained from the above barium titanate were excellent in their characteristics.

### Example 12

A perovskite-type BaTiO₃ micro-particle powder was produced in a manner similar to that of Example 1. The powder was crystallized at 300°C for two hours. The specific surface area and c/a ratio of the product were measured in a manner similar to that of Example 1, and found to be 45 m²/g and 1.0000, respectively. Infrared spectroscopic analysis was performed in a manner similar to that of Example 1. As a result, the sample was found not to exhibit a steep absorption peak in the vicinity of 3,500 cm⁻¹ attributed to an interstitial hydroxyl group.

### Comparative Example 1:

An oxalic acid aqueous solution was heated to 80°C under stirring, and an aqueous solution of a mixture of BaCl₂ and TiCl₄ was added dropwise to the oxalic acid aqueous solution, to thereby yield barium titanyl oxalate. The thus-obtained sample was washed with water for removing chlorine therefrom, and subsequently the sample was thermally decomposed at 950°C, to thereby produce BaTiO₃. The specific surface area and c/a ratio of the resultant BaTiO₃ were measured in a manner similar to that of Example 1, and found to be 4 m²/g and 1.0088, respectively. The carbonate group content of the sample was measured by use of an infrared spectrometer, and as a result, the carbonate group content was found to be 8 mass% as reduced to barium carbonate. Since large amounts of carbonate groups (i.e., an impurity) are generated in the BaTiO₃, the BaTiO₃ has a low tetragonality content. In addition, the sample was found to exhibit a steep absorption peak in the vicinity of 3,500 cm⁻¹ attributed to interstitial hydroxyl groups. Conceivably, dielectric characteristics of the BaTiO₃ serving as a dielectric material are unsatisfactory. The dielectric constant at 25°C was 2000. The temperature characteristic thereof satisfied the X7R characteristic of EIA standard.

### Comparative Example 2:

The brookite titanium dioxide sol synthesized in Example 1 (667 g), barium hydroxide octahydrate (592 g) (Ba/Ti mol ratio: 1.5), and ion exchange water (1 L) were placed in a 3-L autoclave, and the resultant mixture was subjected to hydrothermal treatment under saturation vapor pressure at 150°C for one hour. The resultant sample was washed with water for removing excess barium therefrom, and the sample was crystallized at 800°C for two hours. The specific surface area and c/a ratio of the resultant sample were measured in a manner similar to that of Example 1, and found to be 6.9 m²/g and 1.0033, respectively. The sample was evaluated by use of an infrared spectrometer, and found to exhibit a steep absorption peak in the vicinity of 3,500 cm⁻¹ corresponding to hydroxyl groups contained in the crystal lattice. Conceivably, when barium titanate is produced through a hydrothermal synthesis method, since a hydroxyl group enters a crystal lattice, the resultant barium titanate has a low tetragonality content. The dielectric constant at 25°C was 1200. The temperature characteristic thereof did not satisfy the X7R characteristic of EIA standard. This was caused by a low crystalinity, by which MgO, HO₂O₃ and BaSiO₃ were diffused into the inside of the barium titanate.

### Comparative Example 3:

The procedure of Example 1 was repeated, except that TMAH was not added, to thereby synthesize a barium titanate. In this case, the pH of the alkaline solution became 10.2. The actual yield of the powder was found to be 86% of the theoretical yield. The results show that when the pH of the alkaline solution is lowered, the barium titanate yield decreases to a non-practical level.

### Comparative Example 4:

The procedure of Example 1 was repeated, except that KOH was employed in place of TMAH, to thereby synthesize a barium titanate. The actual yield of the barium titanate was found to be 99.9% of the theoretical yield. The barium titanate was subjected to filtration, and the resultant sample was washed with water until the K content became 100 ppm. The sample was crystallized at 800°C for two hours. The specific surface area and c/a ratio of the resultant sample were measured in a manner similar to that of Example 1, and found to be 9 m²/g and 1.0030, respectively. The sample was evaluated by use of an infrared spectrometer, and found to exhibit a steep absorption peak in the vicinity of 3,500 cm⁻¹ attributed to hydroxyl groups contained in the crystal lattice. The dielectric constant at 25°C was 900. The temperature characteristic thereof did not satisfy the X7R characteristic of EIA standard. This was caused by a low crystalinity, by which MgO, HO₂O₃ and BaSiO₃ were diffused into the inside of the barium titanate. Furthermore, the Ba/Ti mol ratio was found to have decreased 0.007 from that before washing of the sample; i.e., Ba, along with K, was eluted through washing of the sample.

### Comparative Example 5:

The procedure of Example 1 was repeated, except that a TMAH having a carbonate group content of 1,000 mass ppm was employed in place of the TMAH having a carbonate group content of 60 mass ppm, to thereby synthesize a barium titanate. The actual yield of the barium titanate was found to be 99.4% of the theoretical yield. The barium titanate was crystallized at 880°C for two hours. The specific surface area and c/a ratio of the resultant sample were measured in a manner similar to that of Example 1, and found to be 8.3 m²/g and 1.0058, respectively. The dielectric constant at 25°C was 1400. The temperature characteristic thereof did not satisfy the X7R characteristic of EIA standard. This was caused by a low crystalinity, by which MgO, HO₂O₃ and BaSiO₃ were diffused into the inside of the barium titanate.

**Table 1**

| Firing temperature | BET | Reduced particle diameter | a-axis length | c-axis length | c/a |
|---|---|---|---|---|---|
| (°C) | (m²/g) | (µm) | (nm) | (nm) | |
| 300 | 42.0 | 0.024 | 0.40102 | 0.40222 | 1.0030 |
| 500 | 40.3 | 0.025 | 0.40087 | 0.40230 | 1.0036 |
| 600 | 32.5 | 0.031 | 0.40068 | 0.40197 | 1.0032 |
| 700 | 20.2 | 0.049 | 0.40037 | 0.40170 | 1.0033 |
| 800 | 13.6 | 0.074 | 0.39986 | 0.40225 | 1.0060 |
| 900 | 6.4 | 0.157 | 0.39944 | 0.40295 | 1.0088 |
| 1000 | 2.1 | 0.471 | 0.39943 | 0.40286 | 1.0086 |

### Industrial Applicability

The barium titanate which contains no hydroxyl groups or defects resulting from removal of hydroxyl groups inside the particles thereof has a small particle size and exhibits excellent electric characteristics such as a high dielectric constant. Small-scale electronic parts such as a multi-layer ceramic capacitor can be produced from a dielectric material such as a dielectric ceramic material obtained from the barium titanate. When such an electronic part is used in an electronic apparatus, the dimensions and the weight of the electronic apparatus can be reduced.

Further, the barium titanate of the present - invention or the slurry comprising the barium titanate of the present invention can provide a dielectric film which has excellent dielectric properties.

The above dielectric film can be applied to a capacitor in or on a substrate since its dielectric properties are so excellent that a thin film made from the dielectric film can have excellent dielectric properties. When such a capacitor can be used in an electronic equipment such as a cell phone or a digital camera, it is very useful in making the equipment miniaturized, lightened and to have a higher performance.

## Claims

1. A barium titanate, which is single crystal in the form of particles, said particles comprising particles without a void having a diameter of 1 nm or more in an amount of 20% or more by number of the total particles.

2. The barium titanate according to claim 1, wherein said particles comprises particles without a void having a diameter of 1 nm or more in an amount of 50% or more by number of the total particles.

3. The barium titanate according to claim 1, wherein said particles comprises particles without a void having a diameter of 1 nm or more in an amount of 80% or more by number of the total particles.

4. The barium titanate according to any one of claims 1 to 3, wherein the particles have a BET specific surface area of 0.1 m²/g or more.

5. The barium titanate according to any one of claims 1 to 4, wherein no abrupt peak is detected at around 3500cm⁻¹ by infrared spectrum analysis of the particles after heat treatment thereof at 700°C.

6. The barium titanate according to any one of claims 1 to 5, comprising at least one element selected from the group consisting of Sn, Zr, Ca, Sr, Pb, Ho, Nd, Y, La, Ce, Mg, Bi, Ni, Al, Si, Zn, B, Nb, W, Mn, Fe, Cu, and Dy, said at least one element being in an amount of less than 5 mol% (0 mol% inclusive) on the basis of the entirety of BaTiO₃.

7. The barium titanate according to any one of claims 1 to 6, which is in the form of powder.

8. The barium titanate according to any one of claims 1 to 7, which is synthesized by wet process.

9. A slurry comprising the barium titanate according to any one of claims 1 to 8.

10. A paste comprising the barium titanate according to any one of claims 1 to 8.

11. A dielectric material comprising barium titanate according to any one of claims 1 to 8.

12. A dielectric ceramic comprising barium titanate according to any one of claims 1 to 8.

13. A piezoelectric material comprising barium titanate according to any one of claims 1 to 8.

14. A piezoelectric ceramic material comprising barium titanate according to any one of claims 1 to 8.

15. A dielectric film material comprising barium titanate according to any one of claims 1 to 8.

16. A capacitor comprising the dielectric material according to claim 11.

17. A capacitor comprising the piezoelectric material according to claim 13.

18. A capacitor comprising the dielectric film according to claim 15.

19. An integrated capacitor comprising the dielectric film according to claim 15.

20. A printed board comprising the dielectric film according to claim 15.

21. An electronic equipment comprising the capacitor according to any one of claims 16 to 19.

## Patentansprüche

1. Bariumtitanat, welches ein Einkristall in Form von Teilchen ist, wobei die Teilchen Teilchen, die keinen Hohlraum mit einem Durchmesser von 1 nm oder mehr aufweisen, in einem Anteil von 20% or mehr der Anzahl der gesamten Teilchen umfassen.

2. Bariumtitanat nach Anspruch 1, wobei die Teilchen Teilchen, die keinen Hohlraum mit einem Durchmesser von 1 nm oder mehr aufweisen, in einem Anteil von 50% or mehr der Anzahl der gesamten Teilchen umfassen.

3. Bariumtitanat nach Anspruch 1, wobei die Teilchen Teilchen, die keinen Hohlraum mit einem Durchmesser von 1 nm oder mehr aufweisen, in einem Anteil von 20% or mehr der Anzahl der gesamten Teilchen umfassen.

4. Bariumtitanat nach einem der Ansprüche 1 bis 3, wobei die Teilchen einen spezifischen Oberflächenbereich nach BET von 0,1 m²/g oder mehr aufweisen.

5. Bariumtitanat nach einem der Ansprüche 1 bis 4, wobei bei Infrarotspektralanalyse der Teilchen kein abrupter Peak bei etwa 3500 cm⁻¹ nach Hitzebehandlung dieser bei 700°C detektiert wird.

6. Bariumtitanat nach einem der Ansprüche 1 bis 5, umfassend mindestens ein Element, das aus der Gruppe ausgewählt ist, bestehend aus Sn, Zr, Ca, Sr, Pb, Ho, Nd, Y, La, Ce, Mg, Bi, Ni, Al, Si, Zn, B, Nb, W, Mn, Fe, Cu und Dy, wobei das mindestens eine Element in einem Anteil von weniger als 5 mol% (einschließlich 0 mol%), bezogen auf die Gesamtheit des BaTiO₃, vorliegt.

7. Bariumtitanat nach einem der Ansprüche 1 bis 6, wobei es in Form eines Pulvers vorliegt.

8. Bariumtitanat nach einem der Ansprüche 1 bis 7, welches durch ein Nassverfahren synthetisiert wird.

9. Aufschlämmung, welche das Bariumtitanat nach einem der Ansprüche 1 bis 8 enthält.

10. Paste, welche das Bariumtitanat nach einem der Ansprüche 1 bis 8 enthält.

11. Dielektrisches Material, welches das Bariumtitanat nach einem der Ansprüche 1 bis 8 enthält.

12. Dielektrische Keramik, welche das Bariumtitanat nach einem der Ansprüche 1 bis 8 enthält.

13. Piezoelektrisches Material, welches das Bariumtitanat nach einem der Ansprüche 1 bis 8 enthält.

14. Piezoelektrisches Keramikmaterial, welches das Bariumtitanat nach einem der Ansprüche 1 bis 8 enthält.

15. Dielektrisches Filmmaterial, welches das Bariumtitanat nach einem der Ansprüche 1 bis 8 enthält.

16. Kondensator, welcher das dielektrische Material nach Anspruch 11 enthält.

17. Kondensator, welcher das piezoelektrische Material nach Anspruch 13 enthält.

18. Kondensator, welcher den dielektrischen Film nach Anspruch 15 enthält.

19. Integrierter Kondensator, welcher den dielektrischen Film nach Anspruch 15 enthält.

20. Leiterplatte, welche den dielektrischen Film nach Anspruch 15 enthält.

21. Elektronische Vorrichtung, welche den Kondensator nach einem der Ansprüche 16 bis 19 enthält.

## Revendications

1. Titanate de baryum, qui est monocristallin sous la forme de particules, lesdites particules comprenant des particules sans un vide ayant un diamètre de 1 nm ou plus, en une quantité de 20 % ou plus en fonction du nombre total de particules.

2. Titanate de baryum selon la revendication 1, dans lequel lesdites particules comprennent des particules sans un vide ayant un diamètre de 1 nm ou plus, en une quantité de 50 % ou plus, en fonction du nombre total de particules.

3. Titanate de baryum selon la revendication 1, dans lequel lesdites particules comprennent des particules sans un vide ayant un diamètre de 1 nm ou plus, en une quantité de 80 % ou plus, en fonction du nombre total de particules.

4. Titanate de baryum selon l'une quelconque des revendications 1 à 3, dans lequel les particules ont une surface spécifique BET de 0,1 m²/g ou plus.

5. Titanate de baryum selon l'une quelconque des revendications 1 à 4, dans lequel aucun pic abrupt n'est détecté à environ 3 500 cm⁻¹ par analyse du spectre infrarouge des particules après traitement thermique de celles-ci à 700°C.

6. Titanate de baryum selon l'une quelconque des revendications 1 à 5, comprenant au moins un élément choisi dans le groupe comprenant le Sn, le Zr, le Ca, le Sr, le Pb, le Ho, le Nd, l'Y, le La, le Ce, le Mg, le Bi, le Ni, l'Al, le Si, le Zn, le B, le Nb, le W, le Mn, le Fe, le Cu et le Dy, ledit élément étant en une quantité inférieure à 5 % molaires (y compris 0 % molaire) sur la base de l'intégralité du BaTiO₃.

7. Titanate de baryum selon l'une quelconque des revendications 1 à 6, qui est sous la forme de poudre.

8. Titanate de baryum selon l'une quelconque des revendications 1 à 7, qui est synthétisé par procédé humide.

9. Suspension comprenant le titanate de baryum selon l'une quelconque des revendications 1 à 8.

10. Pâte comprenant le titanate de baryum selon l'une quelconque des revendications 1 à 8.

11. Matériau diélectrique comprenant du titanate de baryum selon l'une quelconque des revendications 1 à 8.

12. Céramique diélectrique comprenant du titanate de baryum selon l'une quelconque des revendications 1 à 8.

13. Matériau piézo-électrique comprenant du titanate de baryum selon l'une quelconque des revendications 1 à 8.

14. Matériau céramique piézo-électrique comprenant du titanate de baryum selon l'une quelconque des revendications 1 à 8.

15. Matériau de film diélectrique comprenant le titanate de baryum selon l'une quelconque des revendications 1 à 8.

16. Condensateur comprenant le matériau diélectrique selon la revendication 11.

17. Condensateur comprenant le matériau piézo-électrique selon la revendication 13.

18. Condensateur comprenant le film diélectrique selon la revendication 15.

19. Condensateur intégré comprenant le film diélectrique selon la revendication 15.

20. Circuit imprimé comprenant le film diélectrique selon la revendication 15.

21. Equipement électronique comprenant le condensateur selon l'une quelconque des revendications 16 à 19.
